# EUROPEAN PATENT APPLICATION

(11) **EP 2 905 815 A1**
(43) Date of publication of application: **12.08.2015**
(21) Application number: 13844398.1
(22) Date of filing: 03.10.2013
(51) Int. Cl.: H01L 31/042, C08K 5/07, C08K 5/5397, C08L 23/08, H01L 31/052

(54) **SEALING FILM FOR SOLAR CELLS AND SOLAR CELL USING SAME**

(30) Priority: 03.10.2012 JP 2012220952; 03.10.2012 JP 2012220951; 01.08.2013 JP 2013160077; 01.08.2013 JP 2013160075
(71) Applicant: Bridgestone Corporation, Tokyo 104-8340 (JP)
(72) Inventor: KATAOKA Hisataka, Yokohama-shi Kanagawa 244-8510 (JP)
(74) Representative: Oxley, Robin John George
(86) International application number: PCT/JP2013/076910
(87) International publication number: WO 2014/054720

(57) **Abstract**

A solar cell sealing film that improves power generation efficiency of a solar cell element due to the presence of a wavelength conversion material therein, and sufficiently maintain the effect of improving power generation efficiency even if a solar cell module is used for a long term, and a solar cell module are provided.

A solar cell sealing film comprising a resin material comprising an olefin (co)polymer, and a wavelength conversion material, wherein the wavelength conversion material is a europium complex represented by the following formula (I): 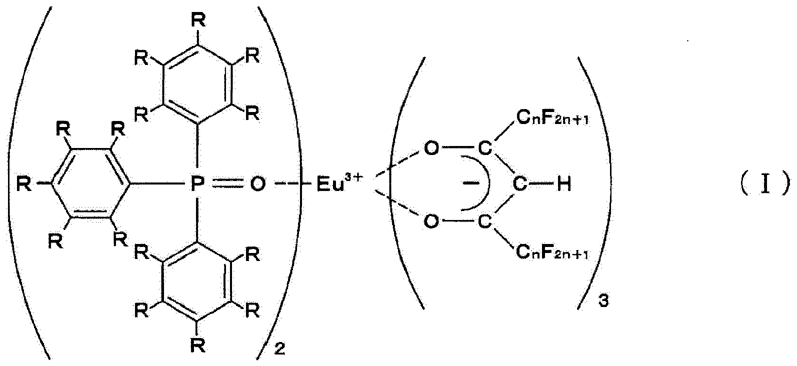 where each R independently represents a hydrogen atom or a hydrocarbon group having 1 to 20 carbon atoms that may optionally be substituted; and n represents an integer of 1 to 4;and a solar cell module prepared by using the sealing film.

## Description

### Technical Field

The present invention relates to a solar cell sealing film containing an olefin (co)polymer as a main component, and particularly relates to a solar cell sealing film capable of improving power generation efficiency by increasing a light beam contributing to power generation of a solar cell module due to the presence of a wavelength conversion material therein.

### Background Art

In recent years, solar cell modules directly converting sunlight into electric energy have been widely used in view of efficient use of resources and prevention of environmental pollution, and further developed for e.g., power generation efficiency and weather resistance.

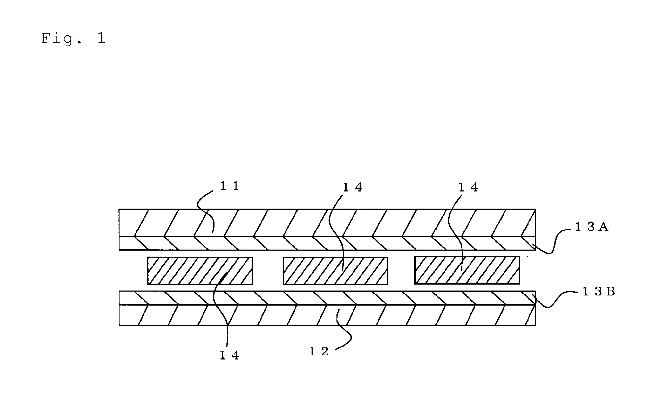

A solar cell module is generally produced by laminating, as shown in Figure 1, a front side transparent protecting member 11 formed of e.g., a glass substrate, a front side sealing film 13A formed of a resin material such as ethylene-vinyl acetate copolymer (EVA), solar cells 14 such as silicon crystal photovoltaic elements, a backside sealing film 13B and a backside protecting member (back cover) 12, in this order, degassing under reduced pressure, and then applying heat and pressure to cure the front side sealing film 13A and the backside sealing film 13B by crosslinking, thereby adhering them into a one body.

Generally, any solar cell element including a silicon crystal photovoltaic element is known to have a problem in that spectral sensitivity to the light beam within the UV region is low and thus sunlight energy cannot be efficiently used. To solve this problem, a technique for improving power generation efficiency of solar cells by using a material (wavelength conversion material) for converting the light beam of the UV region to light beam of the visible region or the near-infrared region, has been proposed. More specifically, a technique for emitting light having a wavelength greatly contributing to power generation of solar cells by converting the wavelength of light within the UV region of the sunlight spectrum by providing a layer containing a fluorescent material on the light-receiving front side of solar cells (for example, Patent Literature 1); a technique involving adding a fluorescent material (for example, a rare-earth complex emitting light of 500 to 1000 nm) to a sealing material (sealing film) for a solar cell module (for example, Patent Literatures 2, 3); and others are proposed.

### Prior Art Literature

### Patent Literature

Patent Literature 1
   JP A 2003-243682
Patent Literature 2
   JP A 2006-303033
Patent Literature 3
   JP A 2011-210891

### Summary of Invention

### Problems to be solved by the Invention

However, when the present inventor made investigation by blending wavelength conversion materials disclosed in the techniques so far proposed into a solar cell sealing film as mentioned above, the inventor found that these wavelength conversion materials significantly deteriorate due to UV rays, and that the wavelength conversion effect thereof decreases when the material is employed in a solar cell module used outside for a long term and the effect of improving power generation efficiency thereof is likely to decrease. It was also found that the wavelength conversion materials each generally have a higher melting point compared to a resin, such as EVA, to be used in the aforementioned sealing film and thus it is difficult to uniformly disperse the material in a sealing film, with the result that wavelength conversion effect varies from site to site; the effect of improving power generation efficiency cannot be sufficiently produced; and the wavelength conversion material easily deteriorates due to aggregation and the like. It was further found that when a solar cell module is used for a long term, the wavelength conversion material also deteriorates due to acid and moisture which may be sometimes formed in the sealing film, with the result that the effect of improving power generation efficiency is likely to more easily decrease.

Accordingly, an object of the present invention is to provide a solar cell sealing film that improves power generation efficiency of a solar cell element due to the presence of a wavelength conversion material therein, and sufficiently maintains the effect of improving power generation efficiency even if the solar cell module is used for a long term.

Another object of the present invention is to provide a solar cell module capable of maintaining high power generation efficiency for a long term by using the solar cell sealing film.

### Means for Solving the Problems

The above objects can be achived by a solar cell sealing film containing a resin material having an olefin (co)polymer (referred to as an olefin polymer or copolymer) and a wavelength conversion material, in which
the wavelength conversion material is a europium complex represented by the following formula (I) : 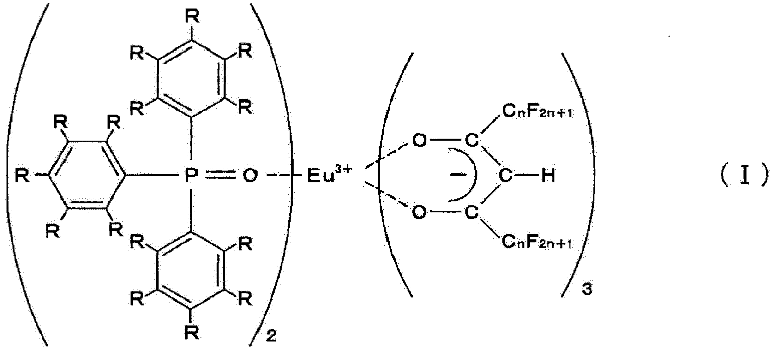 where each R independently represents a hydrogen atom or a hydrocarbon group having 1 to 20 carbon atoms that may be optionally substituted; and n represents an integer of 1 to 4.

As a result of investigation on many wavelength conversion materials, it has been found that it is very rare for a wavelength conversion material formed of a europium complex as mentioned above to cause UV deterioration in a solar cell sealing film. Accordingly, when the wavelength conversion material is used, it is possible to obtain a solar cell sealing film whose effect of improving power generation efficiency rarely reduces even if the solar cell module is used outside for a long term.

### Effects of Invention

Since the solar cell sealing film of the present invention contains a predetermined europium complex as a wavelength conversion material having an effect of improving power generation efficiency, the wavelength conversion material rarely deteriorates by the influence of UV rays, etc., and the effect of improving power generation efficiency is maintained for a long term. Accordingly, the solar cell module of the present invention is a solar cell module maintaining a high power generation efficiency for a long term.

### Brief Description of Drawing

Figure 1 is a schematic sectional view showing a structure of a general solar cell module.

### Description of Embodiments

The solar cell sealing film of the present invention comprises a resin material comprising at least an olefin (co)polymer and, as a wavelength conversion material, a europium complex represented by the following formula (I): 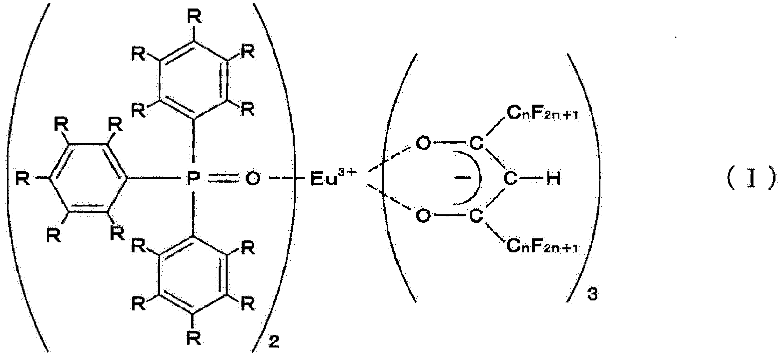 where each R independently represents a hydrogen atom or a hydrocarbon group having 1 to 20 carbon atoms that may optionally be substituted; and n represents an integer of 1 to 4, preferably 1.

Since such a europium complex is extremely excellent in weather-resistance (particularly, UV resistance) compared to other wavelength conversion materials, wavelength conversion effect can be maintained at a high level even if it is used as a sealing film of a solar cell module, which is installed outside and exposed to sunlight for a long time. Since such a europium complex is also excellent in heat resistance compared to other wavelength conversion materials, its wavelength conversion effect can be maintained even if the solar cell module is exposed to sunlight and increases in temperature.

The europium complex represented by formula (I) has an absorption peak near 330 nm, whereas other wavelength conversion materials have absorption peaks near 360 nm. Thus, UV rays having lower rates of contribution to power generation can be converted into visible light and more efficient effect in improving power generation efficiency is achieved. In the meantime, polyester (particularly PET) materials, which are frequently used as a backside protecting member of a solar cell module and a cell fixing tape for arranging solar cells at desired positions during a production process, tend to deteriorate particularly by the UV ray of 330 nm. Therefore, when the europium complex represented by formula (I) is used, deterioration and yellow discoloration of the backside protecting member and cell fixing tape can be reduced.

In the above formula (I), the hydrocarbon group having 1 to 20 carbon atoms may be aliphatic or aromatic; may contain an unsaturated bond and a hetero atom; and may be linear or branched. Examples thereof may include an alkyl group (e.g., a methyl group, an ethyl group, a propyl group), an alkenyl group (e.g., a vinyl group, an allyl group, a butenyl group), an alkynyl group (e.g., an ethynyl group, a propynyl group, a butynyl group), a cycloalkyl group, a cycloalkenyl group, a phenyl group, a naphthyl group and a biphenyl group. The above hydrocarbon group may optionally have a substituent. Examples of the substituent include a halogen atom, a hydroxyl group, an amino group, a nitro group and a sulfo group. All R in formula (I) are preferably hydrogen atoms.

The above europium complex is preferably Eu(hfa)₃(TPPO)₂ represented by formula (I) where n is 1 and all R are hydrogen atoms, because the complex has particularly excellent UV resistance. Eu(hfa)₃(TPPO)₂ is a europium complex in which two ligands, triphenylphosphine oxide and hexafluoro acetylacetone, are coordinated to a center element of europium (a rare-earth metal).

The europium complex represented by formula (I) is preferably added in the range of 0.000001 to 1 part by weight based on 100 parts by weight of the resin material of a solar cell sealing film. If the content is below 0.000001 part by weight, sufficient wavelength conversion effect may not be obtained. The content of a europium complex is further preferably 0.00001 part by weight or more and particularly preferably 0.0001 part by weight or more. In contrast, if the content is beyond 1 part by weight, transparency required for sufficiently introducing sunlight to a photovoltaic element may not be ensured. In addition, such a content is unfavorable in view of cost. The content of a europium complex is further preferably 0.1 part by weight or less and particularly preferably 0.01 part by weight or less.

In the present invention, the europium complex represented by formula (I) is preferably contained in fine particles formed of an acrylic resin and dispersed in a resin material, or supported on the fine particles. Owing to this, a solar cell sealing film having a wavelength conversion material uniformly dispersed therein can be obtained. Namely, since the europium complex represented by formula (I) has a higher melting point than a resin material comprising an ethylene-polar monomer copolymer, it may be difficult for the europium complex to uniformly disperse in the resin material, with the result that the europium complex may be nonuniformly present. In this case, the wavelength conversion effect is nonuniformly obtained and the effect of improving power generation efficiency may not be sufficiently obtained. In addition, deterioration may be likely to occur due to aggregation of the complex and the like. Since the above fine particles are satisfactorily dispersed in the resin material, when the europium complex is contained in or supported on the fine particles, the europium complex can be uniformly dispersed in the resin material. As a result, the effect of improving power generation efficiency can be sufficiently obtained and deterioration of the complex can be suppressed.

Preferably, the europium complex represented by formula (I) is contained in fine particles, because deterioration by acid and moisture, which may be produced in a solar cell sealing film containing an ethylene-polar monomer copolymer, can be more effectively prevented to form a solar cell sealing film which rarely reduces the effect of improving power generation efficiency.

When the europium complex represented by formula (I) as mentioned above is added in the resin material for a solar cell sealing film by containing the europium complex in fine particles or by supporting the europium complex on the europium complex, the content of the europium complex represented by formula (I) in the solar cell sealing film is controlled by the content of the fine particles (described later) containing the europium complex represented by formula (I).

### [Resin material]

In the present invention, the resin material of the solar cell sealing film comprises an olefin (co)polymer as a main component. The olefin (co)polymer herein refers to an olefin polymer or copolymer such as an ethylene-α-olefin (co)polymer (for example, an ethylene-α-olefin copolymer obtained by polymerization using a metallocene catalyst (m-LLDPE)), a polyethylene (for example, low-density polyethylene (LDPE) and a linear low density polyethylene (LLDPE)), polypropylene and a polybutene; and a copolymer of an olefin and a polar monomer such as an ethylene-polar monomer copolymer, which have adhesiveness, transparency and the like required for a solar cell sealing film. As the olefin (co)polymer, these may be used singly or as a mixture of two or more of them. In the present invention, as the olefin (co)polymer, at least one polymer selected from the group consisting of an ethylene-α-olefin copolymer obtained by polymerization using a metallocene catalyst (m-LLDPE), a low density polyethylene (LDPE), a linear low density polyethylene (LLDPE), polypropylene, polybutene and an ethylene-polar monomer copolymer is preferred. Particularly, the olefin (co)polymer is preferably an ethylene-α-olefin copolymer obtained by polymerization using a metallocene catalyst (m-LLDPE) and/or an ethylene-polar monomer copolymer, because the polymer(s) is excellent in processability and capable of forming a crosslinked structure by a crosslinking agent and successfully provides a solar cell sealing film having high adhesiveness.

### (Ethylene-α-olefin copolymer obtained by polymerization using a metallocene catalyst (m-LLDPE))

The polymer, m-LLDPE, is an ethylene-α-olefin copolymer, (also including terpolymer, etc.), which comprises a structural unit derived from ethylene as a main component and further contains single or a plurality of types of structural units derived from an α-olefin having 3 to 12 carbon atoms, such as propylene, 1-butene, 1-hexene, 1-octene, 4-methylpentene-1,4-methyl-hexene-1 and 4,4-dimethyl-pentene-1. Specific examples of the ethylene-α-olefin copolymer may include an ethylene-1-butene copolymer, an ethylene-1-octene copolymer, an ethylene-4-methyl-pentene-1 copolymer, an ethylene-butene-hexene terpolymer, an ethylene-propylene-octene terpolymer and an ethylene-butene-octene terpolymer. The content of α-olefin in the ethylene-α-olefin copolymer is preferably 5 to 40% by weight and more preferably 10 to 35% by weight and further preferably 15 to 30% by weight. If the content of α-olefin is low, flexibility and impact resistance of the resultant solar cell sealing film is not sufficient; in contrast, if the content is excessive, the heat resistance may be low.

The metallocene catalyst for polymerizing m-LLPDE is not particularly limited and a metallocene catalyst known in the art may be used. The metallocene catalyst is generally a combination of a metallocene compound, which is a compound having a structure in which a transition metal such as titanium, zirconium and hafnium is sandwiched by unsaturated cyclic compounds containing e.g., a π electronic system cyclopentadienyl group or a substituted cyclopentadienyl group, and an aluminum compound (serving as a co-catalyst) such as an alkyl aluminoxane, an alkyl aluminum, an aluminum halide and an alkyl aluminum halide. The metallocene catalyst has active spots uniformly present (single site catalyst). Due to the feature, usually, a polymer having a narrow molecular weight distribution and virtually the same content of co-monomer per molecule can be obtained.

In the present invention, the density (according to JIS K 7112, the same will apply to the following) of m-LLDPE is preferably 0.860 to 0.930 g/cm³, but not particularly limited to this. The melt flow rate (MFR) (according to JIS-K7210) of m-LLDPE is preferably 1.0 g/10 min or more, but not particularly limited to this; more preferably, 1.0 to 50.0 g/10 min and further preferably 3.0 to 30.0 g/10 min. The MFR is determined at a temperature of 190°C and a load of 21.18 N.

In the present invention, as m-LLDPE, those which are commercially available can be used. Examples thereof may include Harmolex series and KERNEL series manufactured by Japan Polyethylene Corporation, Evolue series manufactured by Prime Polymer Co., Ltd., Excellen GMH series and Excellen FX series manufactured by Sumitomo Chemical Co., Ltd.

### (Ethylene-polar monomer copolymer)

Examples of the polar monomer of an ethylene-polar monomer copolymer include a vinyl ester, an unsaturated carboxylic acid and a salt, an ester and an amide thereof and carbon monoxide and the like. Specific examples thereof may include one or two or more of vinyl esters such as vinyl acetate and vinyl propionate; unsaturated carboxylic acids such as acrylic acid, methacrylic acid, fumaric acid, itaconic acid, monomethyl maleate, monoethyl maleate, maleic anhydride and anhydrous itaconic acid; salts of the unsaturated carboxylic acids with a monovalent metal such as lithium, sodium and potassium; salts of the unsaturated carboxylic acids with a polyvalent metal such as magnesium, calcium and zinc; esters of unsaturated carboxylic acids such as methyl acrylate, ethyl acrylate, isopropyl acrylate, isobutyl acrylate, n-butyl acrylate, isooctyl acrylate, methyl methacrylate, ethyl methacrylate, isobutyl methacrylate and dimethyl maleate; carbon monoxide and sulfur dioxide.

Specific examples (typical examples) of the ethylene-polar monomer copolymer may include ethylene-vinyl ester copolymers such as an ethylene-vinyl acetate copolymer; ethylene-unsaturated carboxylic acid copolymers such as an ethylene-acrylic acid copolymer and an ethylene-methacrylic acid copolymer; ionomers in which a part or whole of the carboxyl groups of the ethylene-unsaturated carboxylic acid copolymer is neutralized with the aforementioned metals; ethylene-unsaturated carboxylic acid ester copolymers such as an ethylene-methyl acrylate copolymer, an ethylene-ethyl acrylate copolymer, an ethylene-methyl methacrylate copolymer (EMMA), an ethylene-isobutyl acrylate copolymer and an ethylene-n-butyl acrylate copolymer; ethylene-unsaturated carboxylic acid ester-unsaturated carboxylic acid copolymers such as an ethylene-isobutyl acrylate-methacrylic acid copolymer and an ethylene-n-butyl acrylate-methacrylic acid copolymer; and ionomers in which a part or whole of the carboxyl groups thereof is neutralized with the aforementioned metals.

As the ethylene-polar monomer copolymer, an ethylene-polar monomer copolymer having a melt flow rate (defined by JIS K7210) of 35 g/10 min or less, particularly 3 to 6 g/10 min, is preferably used. When an ethylene-polar monomer copolymer having such a melt flow rate is used, a solar cell sealing film having excellent processability can be obtained. In the present invention, the value of the melt flow rate (MFR) is determined in accordance with JIS K7210 at a temperature 190°C and a load of 21.18 N.

As the ethylene-polar monomer copolymer, an ethylene-vinyl acetate copolymer (EVA), an ethylene-methyl methacrylate copolymer (EMMA), an ethylene-ethyl methacrylate copolymer, an ethylene-methyl acrylate copolymer and an ethylene-ethyl acrylate copolymer are preferred, and EVA and EMMA are particularly preferred. Owing to this, a solar cell sealing film which is inexpensive and excellent in transparency and flexibility can be obtained. When such a solar cell sealing film is used, a solar cell module which is more excellent in durability and having high power generation efficiency can be produced.

When EVA is used as a resin material, the content of vinyl acetate in EVA is preferably 20 to 35% by weight based on EVA, further preferably, 22 to 30% by weight and particularly preferably 24 to 28% by weight. The lower the content of a vinyl acetate unit in EVA is, the harder the resultant sheet tends to be. When the content of vinyl acetate is excessively low, the transparency of the sheet obtained through crosslinking/curing at high temperature may not be sufficient. In contrast, if the content of vinyl acetate is excessively high, the hardness of the resultant sheet may be insufficient.

When EMMA is used as a resin material, the content of methyl methacrylate in EMMA is preferably 20 to 30% by weight and further preferably 22 to 28% by weight. If the content falls within the range, a sealing film having high transparency can be obtained and a solar cell module having high power generation efficiency can be obtained.

In the present invention, a resin such as a polyvinylacetal resin (for example, polyvinyl formal, polyvinyl butyral (PVB resin), modified PVB) may be secondarily added to the resin material, in addition to the aforementioned olefin (co)polymer.

### [Crosslinking agent]

The solar cell sealing film of the present invention preferably contains a crosslinking agent to form a crosslinked structure of an olefin (co)polymer (particularly ethylene-polar monomer copolymer). As the crosslinking agent, an organic peroxide or a photopolymerization initiator is preferably used. Of them, an organic peroxide is preferably used since a sealing film improved in adhesion force, humidity resistance and temperature dependency of penetrability resistance can be obtained.

As the organic peroxide, any organic peroxide can be used as long as it is decomposed at a temperature of 100°C or more to generate radicals. The organic peroxide is generally selected in consideration of film forming temperature, conditions for preparing a composition, curing temperature, heat resistance of an object to be attached and storage stability. Particularly, an organic peroxide having a half-life period of 10 hours and a decomposition temperature of 70°C or more is preferable.

Examples of the organic peroxide may include 2,5-dimethyl-2,5-bis(t-butylperoxy)hexane, 2,5-dimethylhexane-2,5-dihydroperoxide, 3-di-t-butylperoxide, dicumylperoxide, 2,5-dimethyl-2,5-bis(t-butylperoxy)hexyne, α,α'-bis(t-butylperoxyisopropyl)benzene, n-butyl-4,4-bis(t-butylperoxy)butane, t-butylperoxyl-2-ethylhexylmonocarbonate, t-hexylperoxyisopropyl monocarbonate, 2,2-bis(t-butylperoxy)butane, 1,1-bis(t-hexylperoxy)-3,3,5-trimethylcyclohexane, 1,1-bis(t-butylperoxy)-3,3,5-trimethylcyclohexane, 1,1-bis(t-butylperoxy)cyclohexane, 2,2-bis(4,4-di-t-butylperoxycyclohexyl)propane, 1,1-bis(t-butylperoxy)cyclododecan, 1,1-bis(t-butylperoxy)cyclohexane and benzoylperoxide curing agent (e.g., t-butyl peroxybenzoate).

As the organic peroxide, particularly, 2,5-dimethyl-2,5-di(tert-butylperoxy)hexane or tert-butylperoxy-2-ethylhexylmonocarbonate is preferable. Owing to this, a solar cell sealing film satisfactorily crosslinked and having excellent transparency can be obtained.

The content of organic peroxide to be used in a solar cell sealing film is preferably 0.1 to 5 parts by weight and more preferably 0.2 to 3 parts by weight based on 100 parts by weight of the resin material. If the content of organic peroxide is low, the crosslinking rate during a crosslinking/curing process may reduce; in contrast, if the content is large, compatibility with a copolymer may deteriorate.

As the photopolymerization initiator, any known photopolymerization initiator can be used, but a photopolymerization initiator exhibiting satisfactory storage stability after blending is desirably used. Examples of such a photopolymerization initiator may include acetophenones such as 2-hydroxy-2-methyl-1-phenylpropan-1-one, 1-hydroxycyclohexylphenylketone and 2-methyl-1-(4-(methylthio)phenyl)-2-morpholinopropane-1; benzoins such as benzyldimethylketal; benzophenones such as benzophenone, 4-phenylbenzophenone and hydroxybenzophenone; and thioxanthones such as isopropylthioxanthone and 2-4-diethyl thioxanthone. Other than these, methylphenylglyoxylate can be used as a specific example. Particularly preferably, e.g., 2-hydroxy-2-methyl-1-phenylpropan-1-one, 1-hydroxycyclohexylphenyl ketone, 2-methyl-1-(4-(methylthio)phenyl)-2-morpholinopropane-1 and benzophenone are mentioned. These photopolymerization initiators can be used, if necessary, as a mixture with one or two types or more photopolymerization accelerators known in the art routinely used such as a benzoate such as 4-dimethyl amino benzoate or a tertiary amine (which is contained in an arbitrary ratio). Alternatively, photopolymerization initiators may be used singly or as a mixture of two or more of them.

The content of the photopolymerization initiator is 0.1 to 5 parts by weight and preferably 0.2 to 3 parts by weight based on 100 parts by weight of the resin material.

### [Crosslinking aid]

The solar cell sealing film of the present invention may contain, if necessary, a crosslinking aid. The crosslinking aid can improve a gel fraction of an olefin (co)polymer and improve the adhesiveness and durability of the sealing film. The crosslinking aid is generally used in an amount of 10 parts by weight or less, preferably 0.1 to 5 parts by weight and further preferably 0.1 to 2.5 parts by weight based on 100 parts by weight of the resin material. Owing to this, a solar cell sealing film further excellent in adhesiveness can be obtained.

Examples of the crosslinking aid (generally, a compound having a radical polymerizable group as a functional group) may include trifunctional crosslinking aids such as triallyl cyanurate and triallyl isocyanurate, a monofunctinal or difunctional crosslinking aids such as (meth)acryl ester (e.g., NK ester). Of them, triallyl cyanurate and triallyl isocyanurate are preferred and particularly triallyl isocyanurate is preferred.

### [Adhesion improver]

The solar cell sealing film of the present invention may further contain an adhesion improver. As the adhesion improver, a silane coupling agent can be used. Owing to this, a solar cell sealing film having further excellent adhesion can be obtained. Examples of the silane coupling agent may include γ-chloropropyltrimethoxysilane, vinyltriethoxysilane, vinyltris(β-methoxyethoxy)silane, γ-methacryloxypropyltrimethoxysilane, vinyltriacetoxysilane, γ-glycidoxypropyltrimethoxysilane, γ-glycidoxypropyltriethoxysilane, β-(3,4-epoxycyclohexyl)ethyltrimethoxysilane, vinyltrichlorosilane, γ-mercaptopropyltrimethoxysilane, γ-aminopropyltriethoxysilane and N-β-(aminoethyl)-γ-aminopropyltrimethoxysilane. These silane coupling agents may be used singly or in combination of two or more of them. Of them, γ-methacryloxypropyltrimethoxysilane is particularly preferred.

The content of the silane coupling agent is preferably 0.1 to 0.7 parts by weight and particularly preferably 0.3 to 0.65 parts by weight based on 100 parts by weight of the resin material.

### [Other components]

The solar cell sealing film of the present invention may further contain, if necessary, various types of additives such as a plasticizer, an acryloxy group-containing compound, methacryloxy group-containing compound and/or an epoxy group-containing compound, in order to improve or control various physical properties (e.g., mechanical strength, optical characteristics such as transparency, heat resistance, light resistance) of a sealing film.

### [Fine particles]

In the present invention, when the europium complex represented by formula (I) is contained in or supported on fine particles, the fine particles are formed of an acrylic resin. The acrylic resin is obtained by polymerizing a (meth)acrylic monomer as a main component and may comprise other monomers copolymerizable with the (meth)acrylic monomer. Examples of the (meth)acrylic monomer may include (meth)acrylic acid, methyl (meth)acrylate, ethyl (meth)acrylate, n-butyl (meth)acrylate, isobutyl (meth)acrylate, dodecyl (meth)acrylate, stearyl (meth)acrylate, 2-ethylhexyl (meth)acrylate and tetrahydrofurfuryl (meth)acrylate. The word "(meth)acryl" represents "acryl or methacryl". These (meth)acrylic monomers may be used singly or in combination of two or more of them. Examples of the monomer copolymerizable with a (meth)acrylic monomer include styrene monomers such as styrene, o-methylstyrene, m-methylstyrene, p-methylstyrene, α-methylstyrene, p-methoxystyrene, p-tert-butylstyrene, p-phenylstyrene, o-chlorostyrene, m-chlorostyrene and p-chlorostyrene; ethylene, propylene, butylene, vinyl chloride, vinyl acetate, acrylonitrile, acrylamide, methacrylamide and N-vinyl pyrrolidone.

In the case where a resin particle having an intermolecular crosslinked structure is obtained, a (meth)acrylic monomer having a plurality of polymerizable double bonds in a molecule may be copolymerized with the above (meth)acrylic monomer. Examples of the crosslinked (meth)acrylic monomer may include (meth)acrylic monomers such as trimethylolpropane triacrylate, ethylene glycol dimethacrylate, diethylene glycol dimethacrylate, triethylene glycol dimethacrylate, decaethylene glycol dimethacrylate, pentadecaethylene glycol dimethacrylate, pentacontahectaethylene glycol dimethacrylate and 1,3-butylene dimethacrylate, allyl methacrylate, trimethylolpropane trimethacrylate, pentaerythritol tetramethacrylate and diethylene glycol dimethacrylate phthalate. These may be used in combination of a plurality of them.

The method for polymerizing monomers for forming a resin is not particularly limited and methods known in the art such as suspension polymerization and emulsion polymerization can be employed. Of them, suspension polymerization is preferred because it has an advantages in that the reaction can be easily controlled. In the suspension polymerization, the aforementioned monomer is polymerized in a solvent such as water in the presence of a polymerization initiator soluble in the monomer. As the polymerization initiator, e.g., a radical polymerization initiator can be used. As the radical polymerization initiator, which is not particularly limited, a peroxide usually used in the art may be mentioned. For example, an organic peroxide producing free radicals by heating and an azo initiator can be used.

Examples of the organic peroxide may include benzoyl peroxide, isobutyl peroxide, methyl ethyl ketone peroxide, t-butyl hydroperoxide and diisopropylbenzene hydroperoxide. Examples of the azo initiator may include 2,2'-azobisisobutyronitrile (azoisobutyronitrile), 2,2'-azobis(2,4-dimethylvaleronitrile), 2,2'-azobis(2-methylbutyronitrile), 2,2'-azobis(4-methoxy-2,4-dimethylvaleronitrile) and dimethyl-2,2'-azobisisobutylate.

Solvent may include organic solvents other than water. Examples of the organic solvents may include alcohols such as methanol, ethanol, isopropanol, n-butanol, isobutanol, sec-butanol, t-butanol, pentanol, ethylene glycol, propylene glycol and 1,4-butanediol; ketones such as acetone and methyl ethyl ketone; esters such as ethyl acetate; (cyclo)paraffin such as isooctane and cyclohexane; aromatic hydrocarbons such as benzene and toluene. These may be used singly or in combination of two or more of them. The addition amount of the polymerization initiator is not particularly limited and appropriately controlled in consideration of the refractive index of fine particles to be formed. The addition amount of the polymerization initiator is generally 0.01 to 10 parts by weight, preferably 0.01 to 2 parts by weight and particularly 0.1 to 1 part by weight based on 100 parts by weight of a monomer.

The refractive index of fine particles formed of an acrylic resin is not particularly limited; however, when the refractive index is excessively high compared to that of a resin material of a sealing film containing an ethylene-polar monomer copolymer, the resultant film is whitened due to reflecting and reduced in transparency and increased in haze value. Accordingly, a resin comprising, as a main component, a poly(methyl (meth)acrylate) obtained by polymerizing methyl (meth)acrylate, which is an acrylic resin having a refractive index equal to or lower than that of the above resin material, is preferred in order not to affect transparency of a solar cell sealing film.

In the present invention, the europium complex represented by formula (I) may be contained in or supported on fine particles, as mentioned above. In order to be contained the europium complex in fine particles, a method of forming fine particles by mixing the europium complex represented by formula (I), together with a polymerizable monomer in forming fine particles from an acrylic resin as mentioned above or a method of forming fine particles by mixing the europium complex represented by formula (I) with dissolved resin may be employed. In particular, a method of forming fine particles by mixing a europium complex represented by formula (I) with a polymerizable monomer is preferred.

In order for a europium complex represented by formula (I) to be supported on fine particles, for example, a method involving dissolving a europium complex represented by formula (I) in a solvent such as acetone and toluene, and mixing the resultant solution with fine particles, followed by drying can be mentioned.

The amount of europium complex represented by formula (I) to be contained in or supported on the fine particle is not particularly limited. The larger the content of an europium complex represented by formula (I) in fine particles is, the higher the emission intensity becomes, and the light resistance and heat resistance tend to increase. In contrast, if the content is extremely high, transparency may be affected. This case is also unfavorable in view of cost. Accordingly, the content of a europium complex represented by formula (I) in fine particles is preferably 0.01 to 5% by weight, more preferably 0.05 to 2% by weight and particularly preferably 0.1 to 1 % by weight.

In the present invention, the shape of a fine particle is not particularly limited; however, a spherical shape is preferred due to dispersibility and low light-scattering. The average particle size of fine particles is not particularly limited; however, if the average particle size is excessively large, the surface area per weight of the fine particles reduces, with the result that luminous efficiency may reduce. In contrast, if the average particle size is excessively small, fine particles easily fly away and are difficult in handling; in addition, the fine particles are likely to mutually bind and reduce in dispersibility. Accordingly, the average particle size of fine particles is preferably 5 to 200 µm, more preferably 20 to 150 µm and particularly preferably 50 to 100 µm.

### [Solar cell sealing film]

The aforementioned solar cell sealing film of the present invention may be formed in accordance with a known method.

The solar cell sealing film can be formed, for example, by a method of forming a sheet by subjecting a composition, which is prepared by mixing the above materials by a known method such as a super mixer (high-speed mixer) or a roll mill, to shaping such as a general extrusion or calender shaping (calendering). Alternatively, a sheet can be obtained by dissolving the composition in a solvent (dispersing in the case of fine particles) and applying the dispersion solution onto an appropriate substrate by an appropriate coater, followed by drying to form a coating film. The heating temperature during the film formation process when an organic peroxide is used is preferably the temperature at which the reaction of the organic peroxide does not proceed or rarely proceeds. The heating temperature is, for example, 50 to 90°C and particularly preferably 40 to 80°C. The thickness of the solar cell sealing film is not particularly limited and appropriately determined depending upon the use. Generally, the thickness of the solar cell sealing film falls within the range of 50 µm to 2 mm.

The solar cell sealing film of the present invention improves power generation efficiency, maintains the effect of improving power generation efficiency even if a solar cell module is used for a long term, due to the presence of a wavelength conversion material in the sealing film, as mentioned above. The effect of improving power generation efficiency is evaluated as follows. The time required for reducing fluorescence intensity of the solar cell sealing film up to 30% relative to that before irradiation is preferably 10 hours or more when the solar cell sealing film, which is arranged at a distance of 235 mm from a UV lamp (having an irradiation intensity of 1000 W/cm²), is continuously irradiated at a temperature of 63°C and the fluorescence intensity is measured with the passage of time, wherein the area of a luminescence peak at a wavelength of 580 to 640 nm in a fluorescence emission spectrum, which is obtained by applying a light beam of 325 nm corresponding to excitation wavelength of a wavelength conversion material (a europium complex represented by formula (I)), to a solar cell sealing film, is specified as the fluorescence intensity,

The fluorescence intensity is determined, for example, as follows. First, a solar cell sealing film as mentioned above, which is prepared so as to have 0.46 mm, is sandwiched by white glass plates of 3.2 mm in thickness, degassed for 2 minutes and pressurized for 8 minutes in a vacuum laminator of 90°C to be crimped, and subjected to a crosslinking reaction performed in an oven of 155°C for 30 minutes to prepare a sample with crosslinkage. The sample obtained is irradiated with a light beam having an excitation wavelength (325 nm in the case of a europium complex represented by formula (I)). The amounts of luminescence at individual wavelengths are measured by a fluorescence spectrophotometer (for example, F-7000, manufactured by Hitachi High-Technologies Corporation) and plotted to obtain a fluorescence emission spectrum. In the fluorescence emission spectrum, the luminescence peak area (luminescence peak area at 580 to 640 nm in the case of a europium complex represented by formula (I)) is calculated and used as the fluorescence intensity. Since the amount of fluorescence is an arbitrary unit varying depending upon the analyzer, the fluorescence intensity value is used in relative comparison in the present invention.

In the solar cell sealing film of the present invention, stability of intensity of fluorescence by the aforementioned UV rays can be evaluated by the following test. A sample of the solar cell sealing film having a crosslinkage as formed above is continuously irradiated by an environment tester (for example, super UV, manufactured by IWASAKI ELECTRIC CO., LTD.) at a black-panel temperature of 63°C and SUV lamp irradiation intensity of 1000 W/cm² at a distance of 235 mm from a light source and the above described fluorescence intensity is measured with the passage of time. Provided that the fluorescence intensity before irradiation is regarded as 100%, the time until the fluorescence intensity reduces up to 30% is measured. If the time is 10 hours or more, it is determined that the solar cell sealing film has sufficient UV tolerance and can sufficiently maintain the effect of improving power generation efficiency, even if the solar cell module is used for a long term.

### [Solar cell module]

The structure of the solar cell module of the present invention is not particularly limited as long as a structure where the solar cell element(s) is/are sealed with the solar cell sealing film of the present invention is contained. For example, a structure where solar cells are sealed by interposing the solar cell sealing films of the present invention between a front side transparent protecting member and a backside protecting member and integrating the solar cell sealing films into a one body by crosslinking, may be mentioned.

Since the solar cell sealing film of the present invention is used in the solar cell module of the present invention, the solar cell elements are improved in power generation efficiency by the wavelength conversion material and a high power generation efficiency of the solar cell module is maintained for a long term.

In the present invention, the side of the solar cell to be irradiated with light (light-receiving side) is referred to as the "front side"; whereas the rear side of the solar cell opposite to the light-receiving surface is referred to as the "backside".

In the solar cell module, solar cells are sufficiently sealed, for example, by laminating a front side transparent protecting member 11, a front side sealing film 13A, solar cells 14, a backside sealing film 13B and a backside protecting member 12 and curing the sealing films in accordance with a customary method such as heating and pressurizing to form crosslinkage.

In the heating and pressurizing process, the laminate obtained by laminating members may be heated and crimped in a vacuum laminator at a temperature of 135 to 180°C, further preferably 140 to 180°C and particularly preferably 155 to 180°C, while degassing for 0.1 to 5 minutes and pressurizing at a pressure of 0.1 to 1.5 kg/cm² for 5 to 15 minutes.

In the heating and pressurizing process, the olefin (co)polymers contained in the front side sealing film 13A and the backside sealing film 13B are crosslinked. In this manner, the front side transparent protecting member 11, backside transparent member 12 and solar cells 14 are integrated via the front side sealing film 13A and backside sealing film 13B to seal the solar cells 14.

Since the power generation efficiency of solar cell elements can be improved by the solar cell sealing film of the present invention due to the presence of a wavelength conversion material therein, as mentioned above, the solar cell sealing film is preferably used as the sealing film to be arranged at the light-receiving surface of the solar cell elements, more specifically as the sealing film 13A to be arranged between the front side transparent protecting member 12 and the solar cells 14 in Figure 1.

The solar cell sealing film of the present invention can be used not only in a solar cell module using solar cells formed of a single crystal or polycrystalline silicon as shown in Figure 1 but also in a thin film solar cell module such as a thin film silicon solar cell module, a thin film amorphous silicon solar cell module and a copper indium serene (CIS) solar cell module. In this case, a structure obtained by laminating the solar cell sealing film of the present invention and a backside protecting member on a thin film solar cell element layer, which is formed by e.g., chemical vapor deposition method on the surface of the front side transparent protecting member such as a glass substrate, a polyimide substrate and a fluorine resin transparent substrate, and adhering them into a one body; a structure obtained by laminating the solar cell sealing film of the present invention and a front side transparent protecting member on a solar cell element formed on the surface of the backside protecting member and adhering them into a one body; or a structure obtained by laminating a front side transparent protecting member, a front side sealing film, a thin film solar cell element, a backside sealing film, and a backside protecting member in this order and adhering them into a one body may be mentioned. In the present invention, the solar cell and thin film solar cell element are collectively referred to as a solar cell element.

The front side transparent protecting member 11 may be generally a glass substrate such as a silicate glass substrate. The thickness of the glass substrate is generally 0.1 to 10 mm and preferably 0.3 to 5 mm. Generally, the glass substrate may be chemically or thermally reinforced.

In the backside protecting member 12, a plastic film such as a polyethylene terephthalate (PET) film and a polyamide film are preferably used. Furthermore, a fluorinated polyethylene film, particularly a film obtained by laminating a fluorinated polyethylene film, an Al film and a fluorinated polyethylene film in this order may be employed in consideration of heat resistance and moist/heat resistance.

The solar cell sealing film of the present invention is characteristically used at the front side and/or the backside of a solar cell module (including thin film solar cell module). Thus, members except the sealing film, such as a front side transparent protecting member, a backside protecting member and solar cells, are not particularly limited as long as they have the same structure as those known in the art.

### Examples

The present invention will be more specifically described by way of Examples as follow.

### 1. Case where a wavelength conversion material is directly added to a solar cell sealing film [Preparation of solar cell sealing film]

Materials were supplied to a roll mill in accordance with the formulation shown in the following tables and kneaded at 70°C to prepare a solar cell sealing film composition. The solar cell sealing film composition was shaped by a calender at 70°C and allowed to cool to prepare a solar cell sealing film (thickness: 0.46 mm).

The wavelength conversion materials are as follows.
Wavelength conversion material (1): Eu(hfa)₃(TPPO)₂ (europium complex represented by formula (I) where all R's are hydrogen atoms and n is 1), Lumisis E-300, manufactured by Central Techno Corporation)
Wavelength conversion material (2): C₆₀H₄₂EuF₉O₈P₂S₃, Lumisis E-400 (manufactured by Central Techno Corporation)
Wavelength conversion material (3): Lumisis R-600 (manufactured by Central Techno Corporation)
Wavelength conversion material (4): Eu(TTA)₃Phen

### [Preparation of sample with crosslinkage]

The solar cell sealing film obtained above was sandwiched by two glass plates (thickness 3.2 mm). The obtained stack was vacuumed for 2 minutes and pressurized for 8 minutes by a vacuum laminator of 90°C to be crimped, and heated in an oven of 155°C for 30 minutes to cure by crosslinking to prepare a sample.

### [Evaluation method]

### (1) Light transmittance (%)

The above sample was subjected to spectral measurement at 400 to 1000 nm by a spectrophotometer (U-4100, manufactured by Hitachi, Ltd.). The average value thereof was determined as a light transmittance (%).

### (2) Haze (turbidity) (%)

The above sample was measured by a haze mater (NDH 2000, manufactured by Nippon Denshoku Industries Co., Ltd.) in accordance with JIS K 7105 (2000) to obtain a haze value (%).

### (3) Fluorescence intensity

The above sample was measured by a spectrophotometer (F-7000, manufactured by Hitachi High-Technologies Corporation) to obtain a fluorescence intensity. Measurement conditions are: photomultiplier voltage: 400 V, excitation-side slit: 20 nm, fluorescence-side slit: 10 nm and scan speed: 240 nm/min. Irradiation wavelength in the case of wavelength conversion material (1) was set at 325 nm, those of wavelength conversion materials (2) and (3): 355 nm, and that of wavelength conversion material (4): 365 nm. Note that, however the excitation peak wavelength of each wavelength conversion material by itself is present at a short wavelength side of the irradiation wavelength as mentioned above, the light beam transmittance (absorption by white glass plate) of the white glass plates is present within the UV region. Thus, absorption by the white glass plates tends to increase toward the short wavelength side. As a result, UV ray at the short wavelength side is intensively absorbed and an apparent excitation peak wavelength shifts toward a long wavelength side in a test using the glass composite structure. Because of this, each irradiation wavelength was determined as mentioned above.

The wavelength was plotted on the X axis and the amount of luminescence on the Y axis. The area of the region surrounded by the curve of the resultant function f(x) from the initiation wavelength of a luminescence peak to the termination wavelength thereof and the linear line connecting two points X = X₀ and X₁ on the function f(x) was calculated and defined as a fluorescence intensity.

### (4) UV deterioration

The above sample was irradiated with UV rays by a UV lamp (Super UV, manufactured by IWASAKI ELECTRIC CO., LTD.) at a black-panel temperature of 63°C; more specifically, the sample was arranged at a position at a distance of 235 mm from a light source for applying UV rays (1000 W/cm²) so as to face the light source and irradiated with UV rays. In this case, the time until the emission intensity reduced up to 30% relative to the emission intensity before irradiation was measured.

### [Evaluation results]

The evaluation results are shown in Tables.

**[Table 1]**

| | | Example 1 | Example 2 | Example 3 | Example 4 | Example 5 | Example 6 | Example 7 | Example 8 | Example 9 | Example 10 |
|---|---|---|---|---|---|---|---|---|---|---|---|
| Formulation (parts by weight) | Olefin (co)polymer (1)^{*1} | 100 | 100 | 100 | 100 | 100 | - | - | - | - | - |
| | Olefin (co)polymer (2)^{*2} | - | - | - | - | - | 100 | 100 | 100 | 100 | 100 |
| | Olefin (co)polymer (3)^{*3} | - | - | - | - | - | - | - | - | - | - |
| | Crosslinking agent (1)^{*4} | 1.3 | 1.3 | 1.3 | 1.3 | 1.3 | 1.3 | 1.3 | 1.3 | 1.3 | 1.3 |
| | Crosslinking agent (2)^{*5} | - | - | - | - | - | - | - | - | - | - |
| | Crosslinking aid^{*6} | 1.5 | 1.5 | 1.5 | 1.5 | 1.5 | 1.5 | 1.5 | 1.5 | 1.5 | 1.5 |
| | Silane coupling agent^{*7} | 0.3 | 0.3 | 0.3 | 0.3 | 0.3 | 0.3 | 0.3 | 0.3 | 0.3 | 0.3 |
| | Wavelength conversion material (1) | 0.00001 | 0.0001 | 0.001 | 0.01 | 0.1 | 0.00001 | 0.0001 | 0.001 | 0.01 | 0.1 |
| Evaluation | Light transmittance (%) | 91.18 | 91.16 | 91.16 | 91.16 | 91.19 | 91.22 | 91.21 | 91.22 | 91.20 | 91.20 |
| | Haze (%) | 0.23 | 0.22 | 0.27 | 0.26 | 0.28 | 0.22 | 0.24 | 0.29 | 0.30 | 0.31 |
| | Fluorescence intensity | 220 | 2460 | 29600 | 254500 | 2550900 | 210 | 2560 | 30100 | 288000 | 2687500 |
| | UV deterioration (h) | 12 | 16 | 30 | 55 | 85 | 11 | 15 | 33 | 52 | 85 |

| | | | | | | | | | | | |
|---|---|---|---|---|---|---|---|---|---|---|---|
| Note) *1: EVA (Content of vinyl acetate; 26 weight% (Ultracene 634, manufactured by Tosoh Corporation)) *2: EVA (Content of vinyl acetate; 28 weight% (Ultracene 2B59A, manufactured by Tosoh Corporation)) *3: EVA (Content of vinyl acetate; 32 weight% (Ultracene 750, manufactured by Tosoh Corporation)) *4: 2,5-Dimethyl-2,5-di(t-butylperoxy)hexane (Perhaxa25B, manufactured by NOF CORPORATION) *5: t-Butylperoxy-2-ethylhexyl monocarbonate (PerbutylE, manufactured by NOF CORPORATION) *6: Triallyl cyanurate (TAIC, manufactured by Nippon Kasei Chemical CO., Ltd.) *7: γ-Methacryloxypropyltrimethoxysilane (manufactured by Shin-Etsu Chemical Co., Ltd.) | | | | | | | | | | | |

**[Table 2]**

| | | Example 11 | Example 12 | Example 13 | Example 14 | Example 15 | Example 16 | Example 17 | Example 18 | Example 19 | Example 20 |
|---|---|---|---|---|---|---|---|---|---|---|---|
| Formulation (parts by weight) | Olefin (co)polymer (1)^{*1} | - | - | - | - | - | 100 | 100 | 100 | 100 | 100 |
| | Olefin (co)polymer (2)^{*2} | - | - | - | - | - | - | - | - | - | - |
| | Olefin (co)polymer (3)^{*3} | 100 | 100 | 100 | 100 | 100 | - | - | - | - | - |
| | Crosslinking agent (1)^{*4} | 1.3 | 1.3 | 1.3 | 1.3 | 1.3 | - | - | - | - | - |
| | Crosslinking agent (2)^{*5} | - | - | - | - | - | 0.35 | 0.35 | 0.35 | 0.35 | 0.35 |
| | Crosslinking aid^{*6} | 1.5 | 1.5 | 1.5 | 1.5 | 1.5 | 0.5 | 0.5 | 0.5 | 0.5 | 0.5 |
| | Silane coupling agent^{*7} | 0.3 | 0.3 | 0.3 | 0.3 | 0.3 | 0.3 | 0.3 | 0.3 | 0.3 | 0.3 |
| | Wavelength conversion material (1) | 0.00001 | 0.0001 | 0.001 | 0.01 | 0.1 | 0.00001 | 0.0001 | 0.001 | 0.01 | 0.1 |
| Evaluation | Light transmittance (%) | 91.30 | 91.30 | 91.24 | 91.16 | 91.19 | 91.18 | 91.17 | 91.17 | 91.18 | 91.17 |
| | Haze (%) | 0.19 | 0.24 | 0.23 | 0.28 | 0.29 | 0.23 | 0.20 | 0.22 | 0.25 | 0.27 |
| | Fluorescence intensity | 260 | 2720 | 28700 | 296400 | 2880900 | 270 | 2660 | 29750 | 300400 | 2760900 |
| | UV deterioration (h) | 11 | 12 | 34 | 50 | 86 | 13 | 15 | 35 | 54 | 90 |

| | | | | | | | | | | | |
|---|---|---|---|---|---|---|---|---|---|---|---|
| Note) *1-7: Same as in Table1 | | | | | | | | | | | |

**[Table 3]**

| | | Comparative Example 1 | Comparative Example 2 | Comparative Example 3 | Comparative Example 4 | Comparative Example 5 | Comparative Example 6 | Comparative Example 7 | Comparative Example 8 | Comparative Example 9 |
|---|---|---|---|---|---|---|---|---|---|---|
| Formulation (parts by weight) | Olefin (co)polymer (1)^{*1} | 100 | 100 | 100 | 100 | 100 | 100 | 100 | 100 | 100 |
| | Olefin (co)polymer (2)^{*2} | - | - | - | - | - | - | - | - | - |
| | Olefin (co)polymer (3)^{*3} | - | - | - | - | - | - | - | - | - |
| | Crosslinking agent (1)^{*4} | 1.3 | 1.3 | 1.3 | 1.3 | 1.3 | 1.3 | 1.3 | - | - |
| | Crosslinking agent (2)^{*5} | - | - | - | - | - | - | - | 0.35 | 0.35 |
| | Crosslinking aid^{*6} | 1.5 | 1.5 | 1.5 | 1.5 | 1.5 | 1.5 | 1.5 | 1.5 | 0.5 |
| | Silane coupling agent^{*7} | 0.3 | 0.3 | 0.3 | 0.3 | 0.3 | 0.3 | 0.3 | 0.3 | 0.3 |
| | Wavelength conversion material (1) | - | - | - | - | - | - | - | - | - |
| | Wavelength conversion material (2) | 0.01 | 0.1 | - | - | - | - | - | - | - |
| | Wavelength conversion material (3) | - | - | 0.01 | 0.1 | - | - | - | - | - |
| | Wavelength conversion material (4) | - | - | - | - | 0.01 | 0.1 | - | - | - |
| Evaluation | Light beam transmittance (%) | 91.15 | 90.94 | 91.18 | 91.03 | 91.03 | 89.33 | 91.16 | 91.16 | 91.17 |
| | Haze (%) | 0.33 | 0.47 | 0.23 | 0.41 | 0.32 | 0.52 | 0.32 | 0.28 | 0.29 |
| | Fluorescence intensity | 85470 | 810500 | 100020 | 1154000 | 11010 | 180400 | 0.0 | 0.0 | 0.0 |
| | UV deterioration (h) | 3 | 4 | 4 | 5 | 1.5 | 2 | - | - | - |

| | | | | | | | | | | |
|---|---|---|---|---|---|---|---|---|---|---|
| Note) *1-7: Same as in Table 1 | | | | | | | | | | |

**[Table 4]**

| | | Example 21 | Example 22 | Example 23 | Example 24 | Example 25 | Example 26 | Example 27 | Example 28 | Example 29 | Example 30 |
|---|---|---|---|---|---|---|---|---|---|---|---|
| Formulation (parts by weight) | Olefin (co)polymer (4)^{*8} | 100 | 100 | 100 | 100 | 100 | - | - | - | - | - |
| | Olefin (co)polymer (5)^{*9} | - | - | - | - | - | 100 | 100 | 100 | 100 | 100 |
| | Crosslinking agent (1)^{*4} | 1.3 | 1.3 | 1.3 | 1.3 | 1.3 | 1.3 | 1.3 | 1.3 | 1.3 | 1.3 |
| | Crosslinking agent (2)^{*5} | - | - | - | - | - | - | - | - | - | - |
| | Crosslinking aid^{*6} | 1.5 | 1.5 | 1.5 | 1.5 | 1.5 | 1.5 | 1.5 | 1.5 | 1.5 | 1.5 |
| | Silane coupling agent^{*7} | 0.3 | 0.3 | 0.3 | 0.3 | 0.3 | 0.3 | 0.3 | 0.3 | 0.3 | 0.3 |
| | Wavelength conversion material (1) | 0.00001 | 0.0001 | 0.001 | 0.01 | 0.1 | 0.00001 | 0.0001 | 0.001 | 0.01 | 0.1 |
| Evaluation | Light transmittance (%) | 91.15 | 91.13 | 91.21 | 91.05 | 91.1 | 91.21 | 91.22 | 91.18 | 91.15 | 91.17 |
| | Haze (%) | 1.2 | 1.1 | 1.3 | 1.3 | 1.4 | 0.75 | 0.8 | 0.77 | 0.85 | 0.89 |
| | Fluorescence intensity | 250 | 2600 | 30400 | 245500 | 2606500 | 240 | 2650 | 28500 | 299000 | 2756000 |
| | UV deterioration | 13 | 18 | 32 | 50 | 80 | 15 | 18 | 30 | 55 | 90 |

| | | | | | | | | | | | |
|---|---|---|---|---|---|---|---|---|---|---|---|
| Note) *4-7: Same as in Table 1 *8: m-LLDPE (KS340T, Density; 0.88g/cm³ (Manfuactured by Japan Polyethylene Corporation)) *9: EMMA (Content of methyl methacrylate: 25 weight% (Acryft WK307, manufactured by Sumitomo Chemical Co., Ltd.)) | | | | | | | | | | | |

As shown in the above tables, when the wavelength conversion material (1) (Eu(hfa)₃(TPPO)₂) was used as the wavelength conversion material, the degree of UV deterioration was low compared to the cases where other wavelength conversion materials were used and the wavelength conversion effect was confirmed to be maintained. Furthermore it was confirmed that when the content of Eu(hfa)₃(TPPO)₂ was 0.00001 to 0.1 part by weight and particularly 0.0001 to 0.01 part by weight based on 100 parts by weight of the resin materials (EVA, m-LLDPE, EMMA), fluorescence intensity was high, and it is particularly favorable for improving power generation efficiency.

### 2. Case where fine particles containing a wavelength conversion material are added in solar cell sealing film

### [Preparation of fine particles containing wavelength conversion material (europium complex represented by formula (I))]

### (1) Wavelength conversion material-containing fine particle

Methyl methacrylate (95 parts by weight), ethylene glycol dimethacrylate (5 parts by weight), a wavelength conversion material (1) (Eu(hfa)₃(TPPO)₂, Lumisis E-300, manufactured by Central Techno Corporation) (0.1 part by weight) and an initiator were subjected to suspension polymerization performed in accordance with a customary method to obtain spherical fine particles (average particle size: 100 µm).

### (2) Wavelength conversion material-supporting fine particle

To poly(methyl methacrylate) resin fine particles (average particle size: 100 µm, manufactured by Negami Chemical Industrial Co., Ltd.), an acetone solution of the wavelength conversion material (1) (Eu(hfa)₃(TPPO)₂, Lumisis E-300, manufactured by Central Techno Corporation) was added such that the europium complex was contained in an amount of 0.1 part by weight based on 100 parts by weight of the fine particles (100 parts by weight), stirred and dried to obtain spherical fine particles.

### [Preparation of solar cell sealing film]

Materials were supplied to a roll mill in the formulation shown in the following table and kneaded at 70°C to prepare a solar cell sealing film composition. The solar cell sealing film composition was shaped by calendering at 70°C and allowed to cool to prepare a solar cell sealing film (thickness: 0.46 mm).

Other wavelength conversion materials are the same as in Section 1 above.

### [Preparation of sample with crosslinkage]

A sample was prepared in the same manner as in Section 1 above.

### [Evaluation method]

### (1) Light transmittance (%)

Evaluation was made in the same manner as in Section 1 above.

### (2) Haze (turbidity) (%)

Evaluation was made in the same manner as in Section 1 above.

### (3) Fluorescence intensity

Evaluation was made in the same manner as in Section 1 above.

### (4) UV deterioration

Evaluation was made in the same manner as in Section 1 above.

### (5) Dispersibility evaluation

The above sample was irradiated with a UV lamp (Super UV, manufactured by IWASAKI ELECTRIC CO., LTD.) and the number of luminous points of 0.1 mm or more in a center square (30 mm x 30 mm) of the sample was counted. When the wavelength conversion material is not dispersed sufficiently, the material was aggregated into coarse particles (present in the film), which can be visually observed easily as a large luminous point. If dispersibility is satisfactory, small luminous points are present uniformly within the film. Thus, the number of coarse luminous points are counted and used as a dispersibility index.

### (6) Evaluation of humidity resistance

The above sample was allowed to stand still in the environment of 85°C and 85%RH for 100 hours. The fluorescence intensity values before and after standing still were measured to computationally obtain a residual ratio.

### [Evaluation results]

Individual evaluation results are shown in Tables.

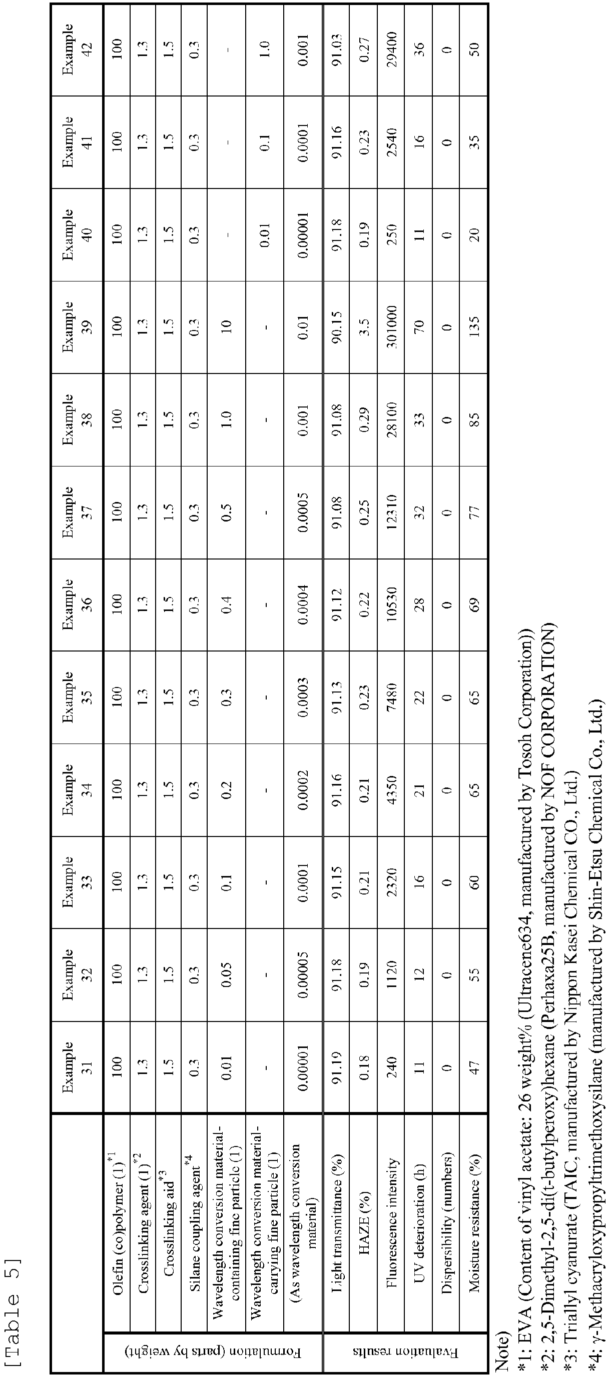

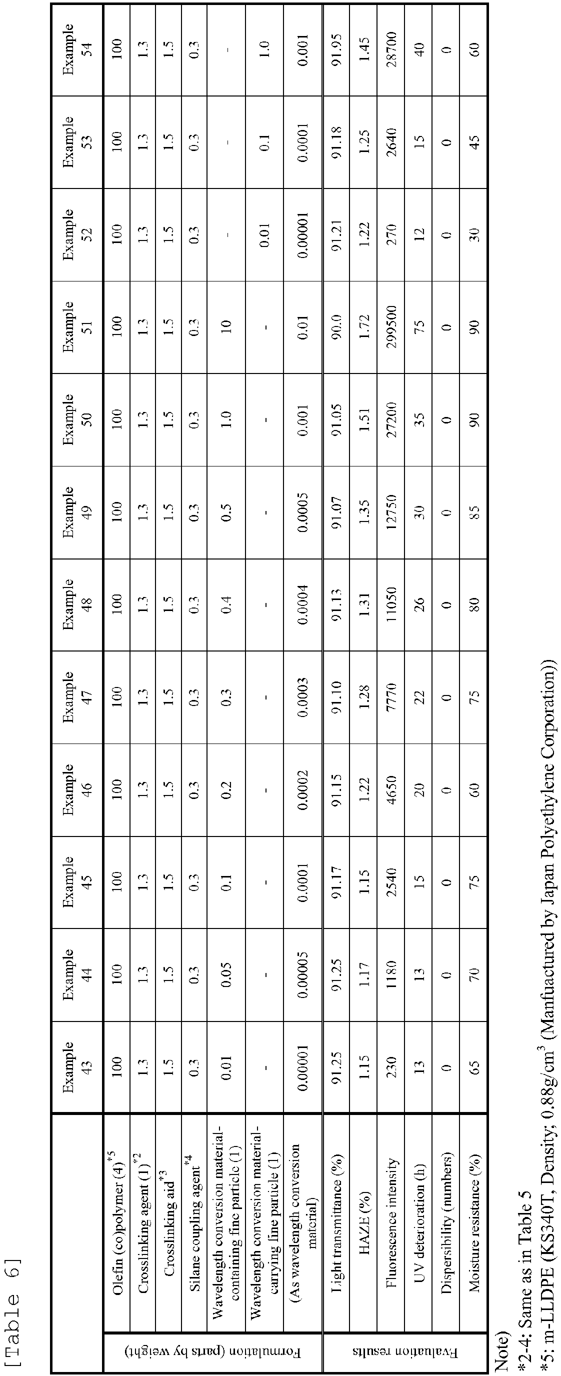

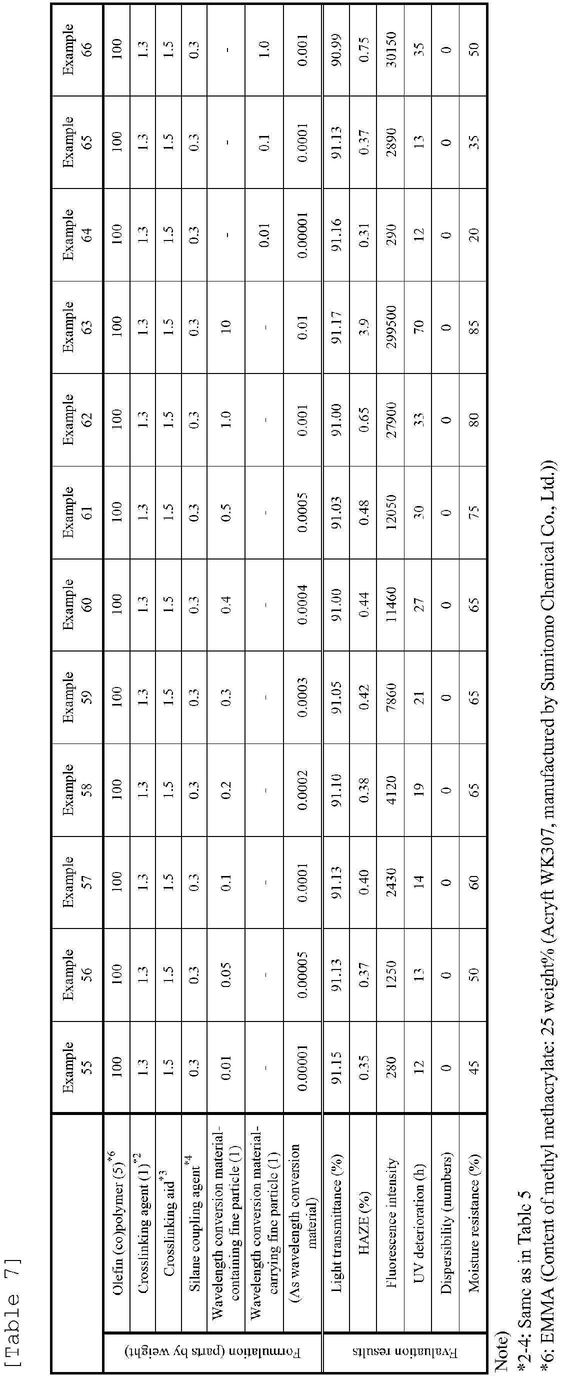

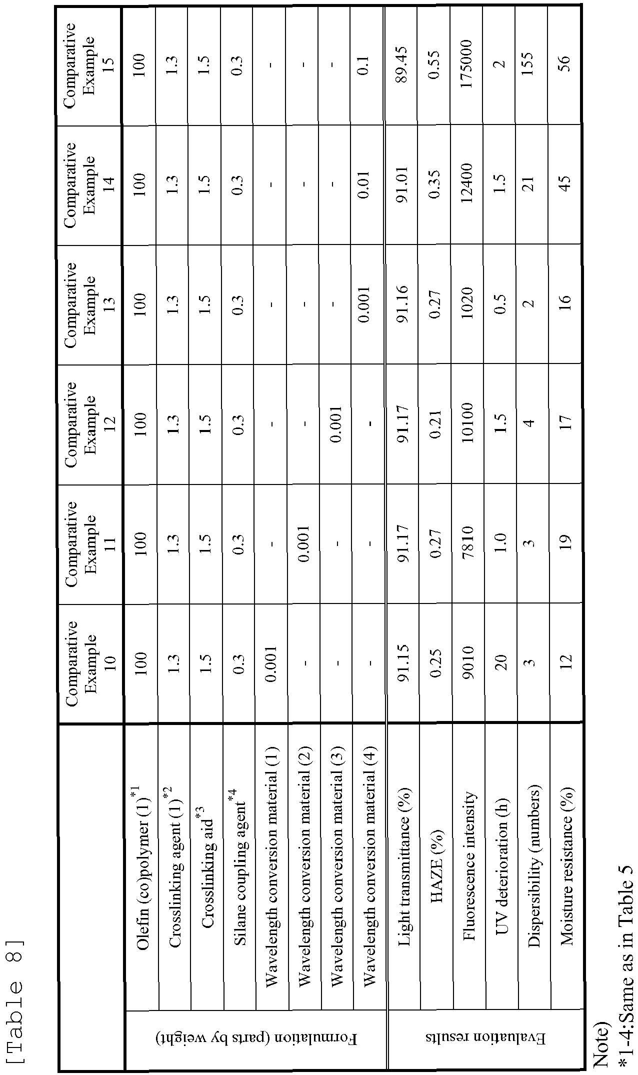

As shown in Tables, the solar cell sealing film, in which fine particles formed of an acrylic resin containing or supporting a europium complex represented by formula (I) are dispersed, has high fluorescence intensity, which rarely reduces even by UV irradiation, and high dispersibility. Accordingly, it was demonstrated that the solar cell sealing film of the present invention has a large effect of improving power generation efficiency and maintains the effect for a long term. If a wavelength conversion material is contained in or not supported on fine particles, dispersibility was low. Note that in the case where a wavelength conversion material except a europium complex represented by formula (I) was used, UV deterioration was significant.

The present invention is not limited by the constitution of Embodiments and Examples mentioned above and can be variously modified within the gist of the invention.

### [Industrial Applicability]

Owing to the present invention, it is possible to provide a solar cell module improved in power generation efficiency of a solar cell element due to a wavelength conversion material and capable of maintaining high power generation efficiency for a long term.

### [Reference Signs List]

- 11: Front side transparent protecting member
- 12: Backside protecting member
- 13A: Front side sealing film
- 13B: Backside sealing film
- 14: Solar cells

## Claims

1. A solar cell sealing film comprising a resin material comprising an olefin (co)polymer, and a wavelength conversion material, wherein
the wavelength conversion material is a europium complex represented by the following formula (I): 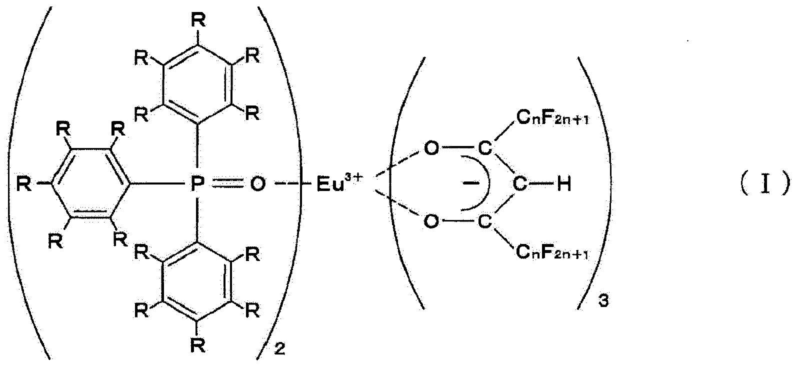 where each R independently represents a hydrogen atom or a hydrocarbon group having 1 to 20 carbon atoms that may optionally be substituted; and n represents an integer of 1 to 4.

2. The solar cell sealing film according to claim 1, wherein, in the above formula (I), all R are hydrogen atoms and n is 1.

3. The solar cell sealing film according to claim 1 or 2 wherein, the content of the wavelength conversion material is 0.000001 to 1 part by weight based on 100 parts by weight of the resin material.

4. The solar cell sealing film according to any one of claims 1 to 3, wherein the content of the wavelength conversion material is 0.0001 to 0.01 part by weight based on 100 parts by weight of the resin material.

5. The solar cell sealing film according to any one of claims 1 to 4, wherein the wavelength conversion material is contained in or supported on fine particles formed of an acrylic resin and the fine particles are dispersed in the resin material.

6. The solar cell sealing film according to claim 5, wherein the wavelength conversion material is contained in the fine particles.

7. The solar cell sealing film according to claim 5 or 6, wherein the acrylic resin is a resin containing poly(methyl (meth)acrylate) as a main component.

8. The solar cell sealing film according to any one of claims 5 to 7, wherein the fine particle is spherical.

9. The solar cell sealing film according to any one of claims 1 to 8, wherein the olefin (co)polymer is one or more polymers selected from the group consisting of an ethylene-α-olefin copolymer (m-LLDPE) obtained by polymerization using a metallocene catalyst, a low density polyethylene (LDPE), a linear low density polyethylene (LLDPE), a polypropylene, a polybutene and an ethylene-polar monomer copolymer.

10. The solar cell sealing film according to any one of claims 1 to 9, wherein the time required for reducing a fluorescence intensity of the solar cell sealing film up to 30% relative to the fluorescence intensity before irradiation is 10 hours or more when the solar cell sealing film, which is arranged at a distance of 235 mm from a UV lamp having an irradiation intensity of 1000 W/cm², is continuously irradiated at a temperature of 63°C and the fluorescence intensity is measured with the passage of time, wherein an area of a luminescence peak at a wavelength of 580 to 640 nm in a fluorescence emission spectrum obtained by applying a light beam of 325 nm corresponding to the excitation wavelength of the wavelength conversion material to the solar cell sealing film is defined as a fluorescence intensity.

11. A solar cell module produced by sealing a solar cell element with the solar cell sealing film according to any one of claims 1 to 10.
